# EUROPEAN PATENT SPECIFICATION

(11) **EP 3 309 959 B1**
(45) Date of publication and mention of the grant of the patent: **21.08.2019**
(21) Application number: 16306356.3
(22) Date of filing: 14.10.2016
(51) Int. Cl.: H03F 1/02, H03F 1/32, H03F 3/193

(54) **AMPLIFICATION SYSTEM AND ENODEB**
VERSTÄRKUNGSSYSTEM UND ENODEB
SYSTÈME D'AMPLIFICATION ET ENODEB

(43) Date of publication of application: 18.04.2018
(73) Proprietor: Nokia Technologies Oy, 02610 Espoo (FI)
(72) Inventor: WANTIEZ, Eric, 91620 NOZAY (FR); DARTOIS, Luc, 91620 NOZAY (FR)
(74) Representative: Nokia EPO representatives

(56) References cited:
- EP-A1- 2 475 094
- EP-A1- 2 750 288
- US-A1- 2005 277 391
- US-A1- 2008 084 244
- US-A1- 2008 111 622
- US-A1- 2012 299 659
- US-B1- 6 556 629
- SEN S ET AL: "Concurrent PAR and power amplifier adaptation for power efficient operation of WiMAX OFDM transmitters", RADIO AND WIRELESS SYMPOSIUM, 2008 IEEE, IEEE, PISCATAWAY, NJ, USA, 22 January 2008 (2008-01-22), pages 21-24, XP031237088, ISBN: 978-1-4244-1462-8

## Description

### FIELD OF INVENTION

The present subject matter relates to an amplification system. For example, this amplification system can be used within a base station or an eNodeB.

### BACKGROUND

Base station sites are the main energy consumers in a mobile network and Radio Frequency (RF) Power Amplifier (PA) consumes more than 50% of the eNodeB total energy, contributing significantly to greenhouse gas (CO2) emissions and operator operational expenses (OPEX). The power amplifier is made of one or several transistors, matching network, combining network, bias circuit, etc. and as per defined architectures aiming to balance linearity as required by 3GPP standard and efficiency. Many power amplifier architectures have been considered. Today two way Doherty power amplifier is the most mature architecture providing with high efficiency performances but only over 6dB dynamic range (9dB for three way Doherty) to address LTE envelop defined by Peak Average Ratio (PAR) at maximum power level. Doherty power amplifier architecture is then optimized for full power while LTE covers much larger dynamic range, linked to the cell load range [0 - 100%].

The problem to solve is to extend the efficiency of the amplification system to wider power range, considering that the load of the amplification system, for example the one integrated within an eNodeB, is statistical. This efficiency needs to be extend without decreasing linearity, in order to still reach the linearity performance defined in 3GPP. The efficiency needs also to be increased over full dynamic range of the amplification system. The resolution of this problem will also help to minimize Capital Expenditure (CAPEX) of the amplification system.

It is known, in the state of the art, a two way Doherty architecture. This is the most mature architecture. It is based on a class AB power amplifier combined with a class C power amplifier. Both being associated with a Digital Pre Distortion (DPD) algorithm. As previously described this architecture cannot solve the above presented problem. An example for such a Doherty architecture comprising Pre Distortion and Crest Factor reduction is given in EP2475094.

It is also known, in the state of the art, a three way Doherty architecture. The aim of this architecture is to extend the high efficiency dynamic by +3dB input power range only. However this architecture has the following drawbacks: a reduced gain, the presence of an additional RF transistor, more complex combining circuit, a video bandwidth limitation, and some additional linearity complexity issues that made the DPD less efficiency regarding spectral performance. These complexity issues limit the use of the three way Doherty architecture, to the amplification of signals at frequency above one GHz (<1 GHz).

It is also known, in the state of the art, Envelop Tracking (ET) architecture. The aim of this architecture is to adapt the maximum power of the power amplifier by dynamically adapt the drain bias according to the envelope of the signal. This technic is promising but not mature enough because of three major not solved issues:
- The low efficiency of envelope tracking modulator (Eff<90%),
- a Video Bandwidth limited to less than 20 MHz and
- a difficulty to obtain a linear amplified signal, because of residual noise coming from the modulator.

It is also known, in the state of the art, switch mode amplification system. Within this amplification system the class of the power amplifier is switched within the different available classes (class D, E, F..). However, this amplification system is very complex (LINC, AMO architecture type. LINC means LInear amplification with Non linear Components, AMO means Asymmetric Multilevel Outphasing) and may require high Ft GaN technology because of high oversampling rate. The idea with switched mode is to feed the amplificatory chain with square signal (=multi harmonic signals according to Fourier decomposition. Amplifier can then be seen as a switch (on/off) with efficiency up to 100%. But implementation constraints and technology limit performances over reduced delivery power and limited bandwidth while market demand is growing thanks to 4G network maturity and coming 5G.

The present subject matter proposes an amplification system and an eNodeB that solve the above defined problem without incurring the drawbacks of the state of the art amplification systems.

### SUMMARY

This summary is provided to introduce concepts related to an amplification system and to equipment, for example an eNodeB comprising this amplification system.

In one implementation an amplification system is described. This amplification system comprises a crest factor reduction module configured to clip the input signal and a digital pre-distortion module configured to pre-distort the clipped signal and at least one power amplifier configured to amplify the pre-distorted signal. Furthermore, within this amplification system, the crest factor reduction module is configured to pass an information representing a Peak Average Ratio of the input signal to the digital pre-distortion module and to the power amplifier, and the crest factor reduction module is configured to dynamically adapt a clipping radius according to a load factor and/or a modulation of the input signal and the digital pre-distortion module being configured to pre distort the clipped signal based on the information. This amplification system also comprises a drain bias controller, providing a drain bias voltage, based on the information, to the power amplifier; and a gate bias controller, providing a gate bias voltage, based on the information, to the power amplifier.

In another implementation an eNodeB is described. This eNode B comprises the amplification system presented in the previous section.

### BRIEF DESCRIPTION OF THE FIGURES

The detailed description is given with reference to the accompanying figures. In the figures, the left-most digit(s) of a reference number identifies the figure in which the reference number first appears. The same numbers are used throughout the figures to reference like features and components. Some embodiments of system and/or methods in accordance with embodiments of the present subject matter are now described, by way of example only, and with reference to the accompanying figures, in which:
Figure 1 presents a first embodiment of the amplification system.
Figure 2 presents a second embodiment of the amplification system.
Figure 3 presents a third embodiment of the amplification system.
Figure 4-a presents a first embodiment of the drain bias controller.

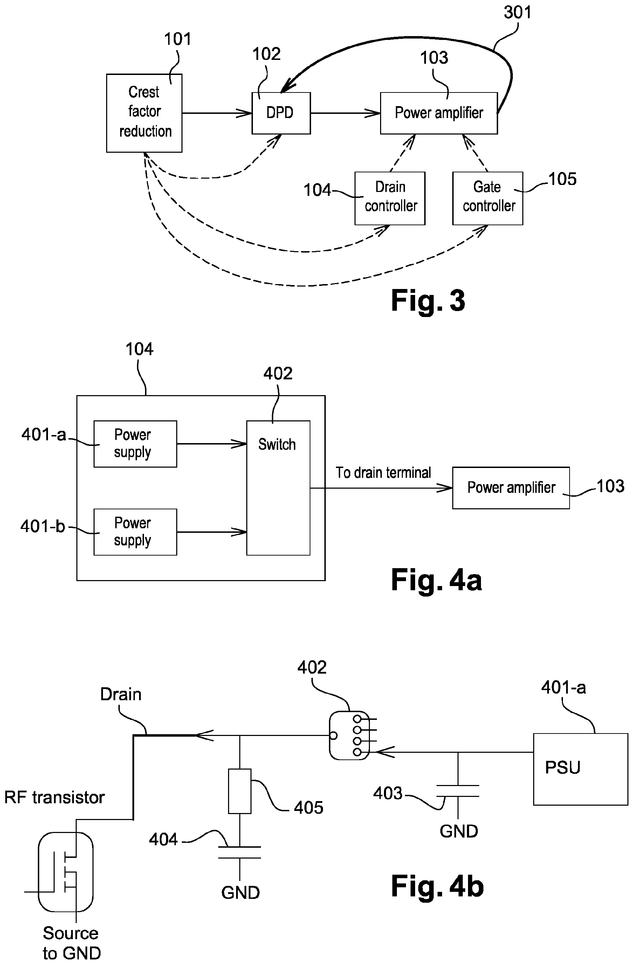

Figure 4-b presents a second embodiment of the drain bias controller.

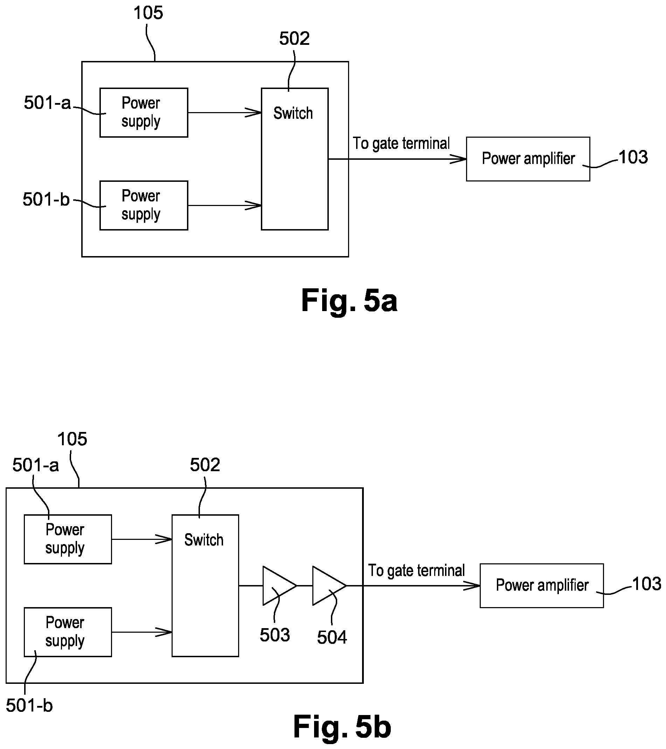

Figure 5-a presents a first embodiment of the gate bias controller
Figure 5-b presents a second embodiment of the gate bias controller

In the present document, the word "exemplary" is used herein to mean "serving as an example, instance, or illustration." Any embodiment or implementation of the present subject matter described herein as "exemplary" is not necessarily to be construed as preferred or advantageous over other embodiments.

It should be appreciated by those skilled in the art that any block diagrams herein represent conceptual views of illustrative systems embodying the principles of the present subject matter. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

### DESCRIPTION OF EMBODIMENTS

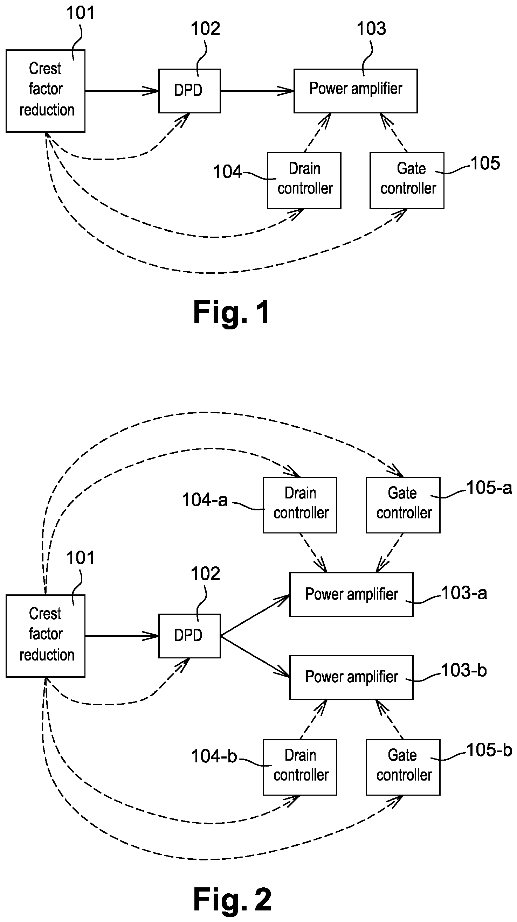

The figure 1 presents a first embodiment of the amplification system. This amplification system comprises
- a crest factor reduction module 101 configured to clip the input signal
- a digital pre-distortion module 102 configured to pre-distort the clipped signal
- at least one power amplifier 103 configured to amplify the pre-distorted signal within this amplification system;
- the crest factor reduction module 101 is configured to pass an information representing a Peak Average Ratio (also known by the acronym PAR) of the input signal to the digital pre-distortion module 102 and to the power amplifier 103, and
- the crest factor reduction module 101 is configured to dynamically adapt a clipping radius according to a load factor and/or a modulation of the input signal and
- the digital pre-distortion module 102 being configured to pre distort the clipped signal based on the information and
this amplification system also comprising
- a drain bias controller 104, providing a drain bias voltage, based on the information, to the power amplifier; and
- a gate bias controller 105, providing a gate bias voltage, based on the information, to the power amplifier.

Load factor here means cell load (0 to 100%), i.e. the ratio between instantaneous usage of the cell and maximum resource available to the cell (for example 20% means 20 Radio blocks allowed versus max 100 Radio Block available with one 20MHz LTE carrier). In LTE, there is no downlink power control, then meaning radio frequency power level of the signal emitted by the eNodeB or base station is directly proportional to load factor.

In an embodiment the input signal comes from a modem and the output of the amplification system is connected to an antenna in which is feed the amplified signal.

The aim of the crest factor reduction module 101 and the digital pre-distortion module 102 is to improve the efficiency of the power amplifier 103 keeping the signal distortion level within 3GPP standard limits as Error Vector Magnitude (EVM) in I&Q domain and/or linearity SEM (Spectrum Emission Mask) in frequency domain. By efficiency, also called drain efficiency, we mean the ratio between the delivered RF power of the amplified signal (Watt) and the delivered power of the power supply (Watt) to the amplification system (or the power amplifier).

The aim of having the crest factor reduction module 101 configured to dynamically adapt a clipping radius according to a load factor and/or a modulation of the input signal is to have peak power amplifier demand decreases at the same time with decreasing average power as per decreasing load and/or decreasing modulation complexity (256QAM to QPSK), so the Peak Average Ratio will also decrease. This allows efficiency improvement when associated to drain bias voltage evolution. In a nutshell multi cycle clipping in frequency domain, LTE symbol per LTE symbol with variable clipping factor linked to modulation, traffic load and EVM budget, taking benefit of the unloaded symbols and LTE carrier spectrum mask to populate the clipping residual dust (then minimizing EVM). As a result, peak average ratio per symbol can be highly reduced with decreasing load thanks to higher freedom to cast residual dust.

In an embodiment the parameters of the different elements of the previously described amplification system are modified in a synchronize way. By evolution of the parameters synchronously we mean that the modification of these parameters are time aligned; especially the change of the crest factor reduction threshold, the digital pre-distortion model update, the transition of the voltage delivered by the drain bias controller 104 and gate bias controller 105. This synchronization doesn't need to be perfect and an amount of misalignments is acceptable as soon as the EVM/SEM budget is meet. This budget is defined at architecture level (Doherty, LINC, mMIMO...) and techno constraints.

Within the previously described embodiment, the crest factor reduction module can also pass the following information to the digital pre distortion module, to the drain bias controller 104 and to the gate bias controller 105 according to:
- The power amplifier technology (ex GaAs, LDMOS, HV LDMOS, GaN)
- The power amplifier architecture (ex: single amplifier chain, 2-way, 3-way Doherty, LINC, AMO)
- The temperature of the system
- The root mean square power of the input signal
- The size of the area of the silicon used by the power amplifier.

Within the previously described embodiment the drain bias controller 104 defines the power amplifier maximum power adaptation capability. The maximum power adaptation capability is the fact to adjust the power amplifier to let him obtain the best efficiency when the power of the output signal is modified. Drain bias control technic as used in envelop tracking (ET), symbol tracking (ST), Envelop elimination and restoration (EER)... allows to surf on stepped transistor output power & associated efficiency curves, as the same manner as one could dynamically adapt the RF transistor silicon size, but without doing any hardware change of the size of transistor silicon. In this divulgation, this is called power size adaptation.

Within the previously described embodiment the gate bias controller 105 tunes the power amplifier class of operation for best linearity/efficiency trade-off over the condition ranges according to the clipped signal, load conditions and drain bias settings.

In other words, this amplification system allows the adaptation of the power amplifier/RF transistor to fit the load of LTE signal with minimum additional circuit & complexity. One way to tune the maximum power adaptation dynamically is to control the gate and/or the drain bias but also, thanks to:
- The crest factor reduction module 101 adapted to realize a crest factor reduction algorithm (CFR) for example the one described within the patent application EP2485447 and
- The drain bias controller 104, configured to allow a discrete Drain bias voltage adaptation. This adaptation is synchronous with an information, delivered by the CFR, representing the Peak Average Ratio (PAR) of the input signal and transient management envelop shaping. For that shaping may be required in order not to cascade Radio Frequency signal envelop and amplifier overshoot during transient. One way to proceed may be to mute the Radio Frequency signal; another way may be to implement a low pass filter (FIR) in digital domain to limit the Radio Frequency signal during these transient period - FIR design shall be designed according to 3GPP spectrum response rules and
- The gate bias controller 105, configured to discretely adapt the gate bias voltage. This adaptation is synchronized with the drain bias voltage adaptation in order to optimize the efficiency/linearity ratio of the class AB power amplifier.

The figure 2 presents a second embodiment of the amplification system. Compared to the first embodiment of the amplification system this second embodiment comprises at least two power amplifiers 103-a & 103-b one power amplifier being a class AB amplifier and one power amplifier being a class C amplifier. Each power amplifiers is associated to a drain bias controller 104-a & 104-b, providing a drain bias voltage, based on the information, to the power amplifier. Each power amplifiers is also associated to a gate bias controller 105-a & 105-b, providing a gate bias voltage, based on the information, to the power amplifier. As for the first embodiment the information represents the Peak Average Ratio of the input signal and is provided by the crest factor reduction module 101.

The class AB amplifier is also called carrier amplifier or main amplifier. The class C amplifier is also called peak amplifier or peaker or auxiliary amplifier.

Within this second embodiment the amplification system can also comprises an input splitter including phase offset according to Doherty rules and a Doherty combiner. By Doherty rules we mean the amplitude & phase combination rules to combine the two ways to meet best power/efficiency performances. Indeed, Doherty principle consider two operating periods:
- 1 low power where only Main path conduct configured in max efficiency mode.
- 2 high power mode where Peak path conduct, combined with Main path which is set in max power mode. Main path moves from off to max power thanks to output load modulation technics which required a 90° line offset at the output. In order to properly combiner main & peak, this 90° offset at the Doherty coupler needs to be compensated in front of the peak path, in this case 90° line offset generally includes in the input splitter block

The aim of this Doherty coupler is to combine the amplified signals at the output of both power amplifier and to feed this combined amplified signals to an antenna.

Within this second embodiment the drain bias controller (104-a or 104-b) associated to the class AB amplifier being configured to reduce, a maximum peak power achievable by the class AB amplifier close to a maximum power at which the input signal needs to be amplified. By "close" we mean between 4dB to 9dB relative to Psat.

Within this second embodiment the gate bias controller or 104-b of the class C amplifier could be configured to modify this gate bias voltage as the rate of samples of an input signal and to allow the commutation of the amplification system between a symmetric and asymmetric mode.

In two way Doherty symmetric mode the input splitter is configured to split equally the signal and to feed the two power amplifier with a signal of same power (half the power of the power of the input signal). In this case both power amplifiers have the same maximum power adaptation and can amplify the signal with the same power (for example 200W each). The asymmetric mode is a mode in which the peak amplifier maximum power adaptation is higher than main amplifier maximum power adaptation. In any case, the peak power amplifier is only active when the signal needs to be amplified at a high power. The aim of the peak power amplifier is to help the main power amplifier, over the highest power signal range. The modification of the gate bias voltage (also called pinch off), thanks to the gate bias controller or 104-b of the peak amplifier allows to move from class C to class B to deliver more gain, then higher power level after Doherty combiner stage. This can be achieved without damaging efficiency as such control is applied on low part of signal Cumulative Complementary Distributive Function (CCDF) curve. This technical feature contributes to minimize the silicon transistor size and equivalent to transistor mode of operation with highest drain voltage that should be delivered by an additional DC/DC converter. This technical feature also improves efficiency by few additional percentage points leading to displacement of all load points efficiency by same amount. When dealing with percentage of traffic load we referred to system capacity, Ex: one 20MHz LTE carrier offers max 100 Radio Blocks to be shared between mobiles according to modem scheduler. 100% means 100 Radio Blocks have been allowed = max PA average power. 70% means 70 Radio Blocks have been allowed in this case the max PA average power - 10^{∗}log(100/70) dB).

In a third embodiment, presented figure 3, the amplification system of the first and second embodiment also comprises:
- a feedback chain loop 301 configured to enter the amplified signal within the digital pre-distortion module and wherein
- the digital pre-distortion module 102 is configured to use the amplified signal.

In a further embodiment of the previous section the digital pre-distortion module 102 is configured to
1. Consider the input signal coming from modem as the input reference (objective: this is the ideal linearity model to meet at power amplifier output)
2. Learn of power amplifier non linearity by capturing samples at power amplifier output
3. Compare between input reference and power amplifier output signal including the determination of time, amplitude & phase misalignment of the signal outing the power amplifier
4. Determine a model of the non-linearity of the power amplifier (for example: the model can be bases on a set of polynomial equations ax²+bx+c)
5. Store of the coefficients (a, b, c) in a data bank
6. Inverse the model of non-linearity of the power amplifier and use this inversed model to predistord the input signal
In an embodiment the different models of non-linearity of the power amplifier are pre-calculated. Each model is associated with a different of the gate and drain bias of the power amplifier. The pre-distortion module 102 is configured to change the model according to the gate and drain bias of the power amplifier. This can be done in a discrete manner by switching data banks, or in continuous manner by adaptation dynamically the nonlinear model, or in hybrid format mixing both.

In another embodiment the amplification system also comprising a phase and/or amplitude controller module configured to modify a phase and/or an amplitude of the input signal. One of the Doherty principle is to combine Main and Peak paths for RF signal closed to maximum power. Combining shall be done in amplitude (equal) & in phase (equal). If combining is not done properly, linearity, bandwidth and efficiency are affected.

Within the amplification system of these three first embodiments the crest factor reduction module 101 can be configured to applies a defined clipping radius to the input signal in order to reduce a Peak Average Ratio of the clipped signal.

Different CFR technics exist but are generally based on iterative algorithm:
- reducing the peak power by summation, to the input signal, of a coherent signal in phase opposition and
- filtering the signal in order to reduce the residual noise. The aim of this filtering is to limit the inter symbol interferences and to limit the noise in and out of the frequency band of the signal (and to respect ACLR/SEM constraints defined for example in the 3GPP specifications)

The state of the art crest factor reduction module that usually applies a fixed clipping radius in order to reduce the Peak Average Ratio (PAR) staying in a given distortion budget as per defined by Error Vector Magnitude (EVM) at maximum RF power with aim to optimize PA sizing & peak power consumption & RM mechanics & thermals. Compare to the state of the art crest factor reduction module, the crest factor reduction module, of the present subject matter, aims to reduce the PAR of the signal over full LTE load range. This result is achieved by adapting clipping radius over the full load range. In this way, instead of keeping high peak power/low overdesigned EVM, better trade-off is applied to please the PA linearity, for example simply keeping constant EVM & constant PAR over the load curve with a clipping radius following linearly the load curve. The crest factor reduction module, of the present subject matter, also allow to relax the power amplifier peak power constraints. As RF signal peak envelop is reduced in deep back-off, linearity would increase at the same time.

The figure 4-a presents an embodiment of the drain bias controller 104. In this embodiment the drain bias controller 104 comprises:
- at least two voltage power supplies 401-a & 401-b and
- a switch 402 configured to switch a connection of a drain terminal of the power amplifier 103 to one of the different power supplies 401-a or 401-b.
In some cases, drain bias current is in average of some amperes while peaks of tens of amperes. Gate bias current is very low (some µA) so much less challenging to switch without capacitor charge/discharge issues.

Figure 4-b presents an embodiment of the drain bias controller 104, as described in the previous section, this drain bias controller 104 could also comprise:
- a first capacitor 403 with a terminal of this first capacitor connected to a point of a first line going from the power supply to the switch and another terminal of the first capacitor is connected to the ground and
- a second capacitor 404 with a terminal of this second capacitor connected to a point of a second line going from the drain terminal of the power amplifier to the switch and another terminal of the second capacitor is connected to the ground and
- A resistance 405, connected between the second capacitor and the second line.
Within this embodiment the first capacitor 403 acts as primary energy reserve with a capacity of some hundreds of µF. A secondary energy reserve is made of the second capacitor 404 with a capacity of few tens of µF associated to the resistance 405 that is less that few ohms.

The drain bias controller 104 could also comprise an energy reserve. The energy reserve can for example be high capacity capacitor (some µFarads). State of the art requires to locate the energy reserve bank as closed as possible to RF transistor device. This localization avoids unexpected inductive parasitic elements that could make the system oscillating or smoothing the energy exchange between power supply and RF transistor. If the energy reserve capacities are not big enough the power supply units (or power supplies) would have to deliver high instantaneously energy. As the power supplies response time is finite, this would cause pulling/pushing effect and delivered voltage becomes instable, so acts as parasitic amplitude modulation effect on RF transistor that can make the system not linearizable. Within this embodiment the RC filter acts not only as hardware protector from breakdown voltage, filter the response such as to simplify the DPD task by the digital pre-distortion module 102. Indeed, time response is much reduced making stabilization delay, and memory effects smaller.

The figure 5-a presents a first embodiment of the gate bias controller 105. In this first embodiment the gate bias controller 105 comprises;
- at least two voltage power supplies 501-a & 501-b and
- a switch configured to switch a connection of a gate terminal of the power amplifier 103 to one of the different power supplies 501-a or 501-b.

The figure 5-b presents a second embodiment of the gate bias controller 105. Compared to the first embodiment, in this second embodiment the gate bias controller 105 also comprises:
- a high gain medium speed buffer 503, with the input terminal of this high gain medium speed buffer connected to the switch with the output terminal of this high gain medium speed buffer connecter to
- a follower medium speed buffer 504, with the input terminal of this follower medium speed buffer connected to the output terminal of the high gain medium speed buffer and the output terminal of this follower medium speed buffer connected to the drain terminal of the power amplifier.

In other words the embodiments of the amplification system, especially the second embodiment, allows the tuning of the peak power amplifier capability in line with radio frequency envelop peak power at crest factor reduction module output, synchronously with the RF signal PAR adaptation thanks to:
- Controlling the drain bias of the main and/or peak power amplifier in discrete manner (Discrete Drain Biasing DDB) is order to keep fixed back-off operation i.e. surf on constant efficiency curves whatever the output power. As the crest factor reduction module clipping radius is adapted to the RF signal symbol (15µs in the case of LTE) or frame load, drain bias adaption can be made at symbol or frame time based i.e. much slower than other technics like Envelop Tracking (ET) that requires sample time based. Regarding the power amplifier, technology such as 50V LDMOS and GaN transistor showing low parasitic effect (Cgs/Cds) over drain voltage dynamic is preferred in order to keep the Doherty combination surfing on Maximum Efficiency / Maximum Peak Power over the drain bias range. Higher parasitic technology such as, 28V LDMOS technology can be used with reduced drain bias range and/or associated input/output matching networks dynamic adaptations. Design investigation technic such as load pull analysis over operational gate & drain biasing helps to evaluate admissible matching & Doherty coupler networks. Furthermore, in this context, amplitude & phase control at Main & Peak power amplifier input path of the Doherty will help by dynamically control the settings synchronously with the switching system. For linearity reason, each Drain bias set needs to address synchronously one digital pre-distortion model adapted & tuned for this particular load range.

One embodiment of the present subject matter is an eNodeB. This ENodeB comprises the amplification system according to any of the previous claims.

In another embodiment this ENodeB also comprises a Base Band Unit (BBU) including a modem, and a Radio Module comprising the amplification system.

In other words, eNodeB is made of Base Band Unit (BBU) including the modem, and Radio Module (RM). Focusing on transmit part, radio module is made of Crest Factor Reduction (CFR) block in charge of Peak Average Ratio (PAR) reduction, followed by Digital PreDistortion (DPD) block that aims to linearize Power Amplifier (PA) thanks to Transmitter (TX) and Feedback (FB) chain loop. Typically, in a MIMOx configuration RM, some of parts are common (FB, and also some others like power supply not showed in this).

This EnodB can take into account the fact that cell traffic is not constantly running at full load all the time. Indeed, the traffic load is linked to number of users & individual loads at different periods of time in the cell. For example, the 4G scheduler dynamically allocate Physical Radio Block (PRB) resources every 1ms making potentially the traffic profile highly bursty. Then Test Models as defined in 3GPP 36.104 are static for design & test verification only but not in line with reality in the networks dependant on the engineering (rural, sub-urban, urban) and services (streaming, MBSFN, VoLTE). Rather ETSI ES 22 706 defines some dynamic models. As no downlink power control is implemented in LTE, eNodeB output power is highly correlated to the load making the signal level highly variable over the time.

## Claims

1. Amplification system comprising:
• a crest factor reduction module (101) configured to clip the input signal and
• a digital pre-distortion module (102) configured to pre-distort the clipped signal and
• at least one power amplifier (103) configured to amplify the pre-distorted signal and within this amplification system;
• the crest factor reduction module (101) is configured to pass an information representing a Peak Average Ratio of the input signal to the digital pre-distortion module (102) and to the power amplifier (103), and
• the crest factor reduction module (101) is configured to dynamically adapt a clipping radius according to a load factor and/or a modulation of the input signal and
• the digital pre-distortion module (102) being configured to pre distort the clipped signal based on the information
this amplification system also comprising
• a drain bias controller (104), providing a drain bias voltage, based on the information, to the power amplifier; and
• a gate bias controller (105), providing a gate bias voltage, based on the information, to the power amplifier.

2. Amplification system according to the claim 1 also comprising:
• at least two power amplifiers (103-a & 103-b) one power amplifier being a class AB amplifier and one power amplifier being a class C amplifier;
each power amplifiers being associated to;
• a drain bias controller (104-a & 104-b), providing a drain bias voltage, based on the information, to the power amplifier; and
• a gate bias controller (105-a & 105-b), providing a gate bias voltage, based on the information, to the power amplifier

3. Amplification system according to the claim 2 wherein
• the drain bias controller (104-a or 104-b) associated to the class AB amplifier being configured to reduce, a maximum peak power achievable by the class AB amplifier close to a maximum power at which the input signal needs to be amplified.

4. Amplification system according to the claim 2 or 3 wherein;
• the gate bias controller (104-a or 104-b) of the class C amplifier modified this gate bias voltage as the rate of samples of the input signal and allow commutation of the amplification system between a symmetric and asymmetric mode.

5. Amplification system according to any of the previous claims also comprising:
• a feedback chain loop (301) configured to enter the amplified signal within the digital pre-distortion module and wherein
• the digital pre-distortion module (102) is configured to use the amplified signal.

6. Amplification system according to any of the previous claims also comprising an amplitude and gain controller module configured to modify a phase or an amplitude of the input signal.

7. Amplification system according to any of the previous claims wherein for each power supply the drain bias controller (104) comprises:
• at least two voltage power supplies (401-a & 401-b) and
• a switch (402) configured to switch a connection of a drain terminal of the power amplifier (103) to one of the different power supplies (401-a or 401-b).

8. Amplification system according to the claim 7 wherein for each power supply the drain bias controller (104) also comprises;
• a first capacitor (403) with a terminal of this first capacitor connected to a point of a first line going from the power supply to the switch and another terminal of the first capacitor connected to the ground and
• a second capacitor (404) with a terminal of this second capacitor connected to a point of a second line going from the drain terminal of the power amplifier to the switch and another terminal of the second capacitor connected to the ground and
• a resistance (405), connected between the second capacitor and the second line.

9. Amplification system according to any of the previous claims wherein for each power supply the gate bias controller (105) comprises;
• at least two voltage power supplies (501-a & 501-b) and
• a switch configured to switch a connection of a gate terminal of the power amplifier (103) to one of the different power supplies (501-a or 501-b).

10. Amplification system according to the claim 9 wherein for each power supply the gate bias controller (105) also comprises:
• a high gain medium speed buffer (503), with the input terminal of this high gain medium speed buffer connected to the switch with the output terminal of this high gain medium speed buffer connecter to
• a follower medium speed buffer (504), with the input terminal of this follower medium speed buffer connected to the output terminal of the high gain medium speed buffer and the output terminal of this follower medium speed buffer connected to the drain terminal of the power amplifier.

11. eNodeB comprising the amplification system according to any of the previous claims.

12. eNodeB according to the claim 11 also comprising
• a Base Band Unit (BBU) including a modem, and
• a Radio Module comprising the amplification system.

## Patentansprüche

1. Verstärkungssystem, umfassend:
• ein Crest-Factor-Reduzierungsmodul (101), das konfiguriert ist, um das Eingangssignal zu kürzen und
• ein digitales Vorverzerrungsmodul (102), das konfiguriert ist, um das gekürzte Signal vorzuverzerren und
• mindestens einen Leistungsverstärker (103), der konfiguriert ist, um das vorverzerrte Signal und innerhalb dieses Verstärkungssystems zu verstärken;
• das Crest-Factor-Reduzierungsmodul (101) ist konfiguriert, um eine Information, die das durchschnittliche Spitzenverhältnis des Eingangssignals zum digitalen Vorverzerrungsmodul (102) und zum Leistungsverstärker (103) darstellt, weiterzugeben, und
• das Crest-Factor-Reduzierungsmodul (101) ist konfiguriert, um einen Kürzungsradius gemäß einem Lastfaktor und/oder einer Modulation des Eingangssignals dynamisch anzupassen und
• das digitale Vorverzerrungsmodul (102) ist konfiguriert, um das gekürzte Signal basierend auf den Informationen vorzuverzerren,
wobei dieses Verstärkungssystem ebenfalls Folgendes umfasst
• eine Drain-Vorspannungssteuerung (104), die dem Leistungsverstärker eine Drain-Vorspannung basierend auf der Information bereitstellt; und
• eine Gate-Vorspannungssteuerung (105), die dem Leistungsverstärker eine Gate-Vorspannung basierend auf den Informationen bereitstellt.

2. Verstärkungssystem nach Anspruch 1, ebenfalls umfassend:
• mindestens zwei Leistungsverstärker (103-a & 103-b), wobei ein Leistungsverstärker ein Verstärker der Klasse AB ist und ein Leistungsverstärker ein Verstärker der Klasse C ist;
wobei jeder Leistungsverstärker Folgendem zugeordnet ist:
• einer Drain-Vorspannungssteuerung (104-a & 104-b), die dem Leistungsverstärker eine Drain-Vorspannung basierend auf den Informationen bereitstellt; und
• eine Gate-Vorspannungssteuerung (105-a & 105-b), die dem Leistungsverstärker eine Gate-Vorspannung basierend auf den Informationen bereitstellt.

3. Verstärkungssystem nach Anspruch 2, wobei:
• die Drain-Vorspannungssteuerung (104-a oder 104-b), die dem Verstärker der Klasse AB zugeordnet ist, konfiguriert ist, um eine maximale Spitzenleistung, die durch den Verstärker der Klasse AB erreichbar ist, auf eine maximale Leistung zu reduzieren, bei der das Eingangssignal verstärkt werden muss.

4. Verstärkungssystem nach Anspruch 2 oder 3, wobei:
• die Gate-Vorspannungssteuerung (104-a oder 104-b) des Verstärkers der Klasse C diese Gate-Vorspannung als Abtastrate des Eingangssignals modifiziert hat und die Kommutierung des Verstärkungssystems zwischen einem symmetrischen und einem asymmetrischen Modus gestattet.

5. Verstärkungssystem nach einem der vorhergehenden Ansprüche, ferner umfassend:
• eine Rückkopplungskettenschleife (301), die konfiguriert ist, um das verstärkte Signal in das digitale Vorverzerrungsmodul einzugeben, und wobei
• das digitale Vorverzerrungsmodul (102) konfiguriert ist, um das verstärkte Signal zu verwenden.

6. Verstärkungssystem nach einem der vorhergehenden Ansprüche, das ebenfalls ein Amplituden- und Verstärkungssteuerungsmodul umfasst, das konfiguriert ist, um eine Phase oder eine Amplitude des Eingangssignals zu modifizieren.

7. Verstärkungssystem nach einem der vorhergehenden Ansprüche, wobei die Drain-Vorspannungssteuerung (104) für jede Stromversorgung Folgendes umfasst:
• mindestens zwei Spannungsversorgungen (401-a & 401-b) und
• einen Schalter (402), der konfiguriert ist, um eine Verbindung eines Drain-Anschlusses des Leistungsverstärkers (103) mit einer der verschiedenen Leistungsversorgungen (401-a oder 401-b) zu schalten.

8. Verstärkungssystem nach Anspruch 7, wobei die Drain-Vorspannungssteuerung (104) für jede Stromversorgung ebenfalls Folgendes umfasst:
• einen ersten Kondensator (403), wobei ein Anschluss dieses ersten Kondensators mit einer Stelle einer ersten Leitung verbunden ist, die von der Stromversorgung zum Schalter führt, und ein weiterer Anschluss des ersten Kondensators mit Masse verbunden ist und
• einen zweiten Kondensator (404), wobei ein Anschluss dieses zweiten Kondensators mit einer Stelle einer zweiten Leitung verbunden ist, die vom Drain-Anschluss des Leistungsverstärkers zum Schalter führt, und ein weiterer Anschluss des zweiten Kondensators mit Masse verbunden ist und
• einen Widerstand (405), der zwischen dem zweiten Kondensator und der zweiten Leitung angeschlossen ist.

9. Verstärkungssystem nach einem der vorhergehenden Ansprüche, wobei die Gate-Vorspannungssteuerung (105) für jede Stromversorgung Folgendes umfasst:
• mindestens zwei Spannungsversorgungen (501-a & 501-b) und
• einen Schalter, der konfiguriert ist, um eine Verbindung eines Gate-Anschlusses des Leistungsverstärkers (103) mit einer der verschiedenen Stromversorgungen (501-a oder 501-b) zu schalten.

10. Verstärkungssystem nach Anspruch 9, wobei die Gate-Vorspannungssteuerung (105) für jede Stromversorgung ebenfalls Folgendes umfasst:
• einen Puffer (503) mit mittlerer Geschwindigkeit und hoher Verstärkung, wobei der Eingangsanschluss dieses Puffers mit mittlerer Geschwindigkeit und hoher Verstärkung mit dem Schalter mit dem Ausgangsanschluss dieses Pufferverbinders mit mittlerer Geschwindigkeit und hoher Verstärkung verbunden ist
• einen nachfolgenden Puffer (504) mit mittlerer Geschwindigkeit, wobei der Eingangsanschluss dieses nachfolgenden Puffers mit mittlerer Geschwindigkeit mit dem Ausgangsanschluss des Puffers mit mittlerer Geschwindigkeit und hoher Verstärkung verbunden ist und der Ausgangsanschluss dieses nachfolgenden Puffers mit mittlerer Geschwindigkeit mit dem Drain-Anschluss des Leistungsverstärkers verbunden ist.

11. eNodeB, umfassend das Amplifikationssystem nach einem der vorhergehenden Ansprüche.

12. eNodeB nach Anspruch 11, ebenfalls umfassend
• eine Basisbandeinheit (BBU) einschließlich eines Modems und
• ein Funkmodul, das das Verstärkungssystem umfasst.

## Revendications

1. Système d'amplification comprenant :
un module de réduction de facteur de crête (101) configuré pour écrêter le signal d'entrée et
un module de pré-distorsion de signal (102) configuré pour pré-distordre le signal écrêté et
au moins un amplificateur de puissance (103) configuré pour amplifier le signal pré-distordu et à l'intérieur du système d'amplification ;
le module de réduction de facteur de crête (101) est configuré pour faire passer des informations représentant un rapport moyen de crête du signal d'entrée au module de pré-distorsion numérique (102) et à l'amplificateur de puissance (103), et
le module de réduction de facteur de crête (101) est configuré pour s'adapter dynamiquement à un rayon d'écrêtage en fonction d'un facteur de charge et/ou d'une modulation du signal d'entrée et
le module de pré-distorsion numérique (102) étant configuré pour pré-distordre le signal écrêté sur la base des informations
ce système d'amplification comprenant également :
un contrôleur de polarisation de drain (104), fournissant une tension de polarisation de drain, sur la base des informations, à l'amplificateur de puissance ; et
un contrôleur de polarisation de grille (105), fournissant une tension de polarisation de grille, sur la base des informations, à l'amplificateur de puissance.

2. Système d'amplification selon la revendication 1, comprenant également :
au moins deux amplificateurs de puissance (103-a & 103-b), un amplificateur de puissance étant un amplificateur de classe AB et un amplificateur de puissance étant un amplificateur de classe C ;
chacun des amplificateurs de puissance étant associé à :
un contrôleur de polarisation de drain (104-a & 104-b), fournissant une tension de polarisation de drain, sur la base des informations, à l'amplificateur de puissance ; et
un contrôleur de polarisation de grille (104-a & 104-b), fournissant une tension de polarisation de grille, basée sur les informations, à l'amplificateur de puissance.

3. Système d'amplification selon la revendication 2, dans lequel
le contrôleur de polarisation de drain (104-a ou 104-b) associé à l'amplificateur de classe AB étant configuré pour réduire une puissance de crête maximum pouvant être obtenue par l'amplificateur de classe AB proche d'une puissance maximum au niveau de laquelle le signal d'entrée a besoin d'être amplifié.

4. Système d'amplification selon la revendication 2 ou 3, dans lequel :
le contrôleur de polarisation de grille (105-a ou 105-b) de l'amplificateur de classe C a modifié cette tension de polarisation de grille en tant que taux d'échantillons du signal d'entrée et permet une commutation du système d'amplification entre un mode symétrique et asymétrique.

5. Système d'amplification selon l'une quelconque des revendications précédentes comprenant également :
une boucle de chaîne de rétroaction (301) configurée pour entrer le signal amplifié à l'intérieur du module de pré-distorsion de signal et dans lequel
le module de pré-distorsion de signal (102) est configuré pour utiliser le signal amplifié.

6. Système d'amplification selon l'une quelconque des revendications précédentes comprenant également un module de contrôleur de gain et d'amplitude configuré pour modifier une phase ou une amplitude du signal d'entrée.

7. Système d'amplification selon l'une quelconque des revendications précédentes, dans lequel pour chaque alimentation électrique le contrôleur de polarisation de drain (104) comprend :
au moins deux alimentations électriques de tension (401-a & 401-b) et
un commutateur (402) configuré pour commuter une connexion d'une borne de drain de l'amplificateur de puissance (103) vers l'une des différentes alimentations électriques (401-a ou 401-b).

8. Système d'amplification selon la revendication 7, dans lequel pour chaque alimentation électrique, le contrôleur de polarisation de drain (104) comprend également :
un premier condensateur (403) ayant une borne du premier condensateur connectée à un point d'une première ligne allant de l'alimentation électrique au commutateur et une autre borne du premier condensateur connectée à la terre et
un second condensateur (404) ayant une borne du second condensateur connectée à un point d'une seconde ligne allant de la borne de drain de l'amplificateur de puissance au commutateur et une autre borne du second condensateur connectée à la terre et
une résistance (405), connectée entre le second condensateur et la seconde ligne.

9. Système d'amplification selon l'une quelconque des revendications précédentes, dans lequel pour chaque alimentation électrique, le contrôleur de polarisation de grille (105) comprend :
au moins deux alimentations électriques de tension (501-a & 501-b) et
un commutateur configuré pour commuter une connexion d'une borne de grille de l'amplificateur de puissance (103) vers l'une des différentes alimentations électriques (501-a ou 501-b).

10. Système d'amplification selon la revendication 9, dans lequel pour chaque alimentation électrique, le contrôleur de polarisation de grille (105) comprend également :
un tampon de vitesse moyenne à gain élevé (503), ayant la borne d'entrée de ce tampon de vitesse moyenne à gain élevé connectée au commutateur avec la borne de sortie de ce tampon de vitesse moyenne à gain élevé connectée à un tampon de vitesse moyenne suiveur (504), ayant la borne d'entrée de ce tampon de vitesse moyenne suiveur connectée à la borne de sortie du tampon de vitesse moyenne à gain élevé et la borne de sortie de ce tampon de vitesse moyenne suiveur connectée à la borne de drain de l'amplificateur de puissance.

11. Noeud B électronique comprenant le système d'amplification selon l'une quelconque des revendications précédentes.

12. Noeud B électronique selon la revendication 11 comprenant également :
une unité de bande de base (BBU) comprenant un modem, et
un module radio comprenant le système d'amplification.
